# EUROPEAN PATENT APPLICATION

(11) **EP 1 930 105 A2**
(43) Date of publication of application: **11.06.2008**
(21) Application number: 08101838.4
(22) Date of filing: 29.11.2005
(51) Int. Cl.: B23B 29/04, C23C 14/06

(54) **Tool holders for chip removing machining**

(30) Priority: 22.12.2004 SE 0403174
(62) Divisional of application: 05445091.1
(71) Applicant: Sandvik Intellectual Property AB, 811 81 Sandviken (SE)
(72) Inventor: Ahlgren, Mats, 187 67 Täby (SE)
(74) Representative: Hägglöf, Henrik

(57) **Abstract**

The present invention relates to a tool holder with a thin outermost colouring non-oxide layer whereby said colour is created by interference.

## Description

The present invention relates to tool holders for chip removing machining provided with an outermost thin interference colour layer.

By a tool holder, is in this application meant a holder for one or more cutting inserts for chip removing machining. The holder includes a base body on which at least one insert-receiving seat or other arrangement for receiving a cutting insert is disposed. For turning applications the tool holders are generally of an elongated shape and for milling applications rotational symmetric. The inserts are made of cemented carbide, cermet, ceramics, high-speed steel, tool steel or the superhard materials such as cubic boron nitride or diamond.

The holders are made from tool steel and manufactured by conventional chip removing machining methods to desired shape and dimension. After that the surface is treated in order to obtain a surface of black oxide. Finally, the surface is oiled to further protect it.

It would of course be very useful if tool holders could be given different colours as a guide to the end user to select the correct one for a certain machining operation but also for decorative reasons. Unfortunately, the number of coloured compounds suitable for such purpose is limited. One method, which is often used, is anodization. Another possibility would be to use Physical Vapour Deposition (PVD)

It is an object of the present invention to provide a tool holder with different colours as a guide to the end user to select the correct one for a certain machining operation.

It is a further object of the present invention to provide a tool holder with a colouring layer with increased wear resistance.

It is a still further object of the present invention to provide a tool holder with a colouring layer that easily can be deposited.

It is yet another object of the present invention to provide a tool holder with a colour that is consistent within a charge as well as between charges.

According to the present invention a tool holder is provided coloured by an outermost thin transparent non-oxide layer, preferably a carbide, nitride or carbonitride layer of a metal from the group comprising groups IVB, VB or VIB of the periodic table, Al, Si and B or mixtures thereof, preferably Ti and/or Al. Its thickness is such that it is coloured by interference, i.e., a thickness of <0.5 µm, preferably 0.05 - 0.3 µm, most preferably 0.05 - <0.2 µm. The body consists of tool steel.

The colour layer may be the only layer but it may also be on top of a wear resistant functional coating. Preferably said colour layer is in contact with a TiN-layer, with a thickness of 0.1 - 5.0 µm.

In a preferred embodiment said colour layer is (Ti,Al)N more specifically TiₓAl₁₋ₓN with 0.1<x<0.9, preferably 0.4<x<0.7, most preferably 0.4<x<0.6.

Preferably, said layer is blue with -20<a*<0, -40<b*<0 and 0<L*<95. In one preferred embodiment -20<a*<-10. In another preferred embodiment -40<b*<-20. The a*, b* and L* coordinates are well-known in the art as part of the CIELab system, a uniform device independent colour space in which colours are located within a three-dimensional rectangular coordinate system. The three dimensions are lightness (L*), redness/greenness (a*) and yellowness/blueness (b*).

The layers are deposited by PVD-technique, preferably by magnetron sputtering or cathodic arc evaporation. Said layers are easily deposited in a production scale equipment in situ with the same set-up as used for the functional wear resistant layers.

Said colour layers can also be deposited with Plasma Assisted Chemical Vapour Deposition (PACVD).

### Example 1

End mill tool holders were provided with a blue outer coating by a sputtering process. A foil 20x20 mm² large in the shape of a cylinder was coated at the same time. Both the tool holders and the foil were subject to the same 3-fold rotation. Ar, Kr and N₂ flow were regulated to 150, 85 and 70 sccm respectively. A negative substrate bias of 100 V was applied. First, a TiN layer of about 0.2 µm was deposited. On top of this TiN-layer a (Ti_{0.5}Al_{0.5})N layer was deposited using two Ti_{0.5}Al_{0.5}-targets as metal sources. By depositing the (Ti_{0.5}Al_{0.5})N layer for 23 minutes with a cathode power of 3.2 kW on each Ti_{0.5}Al_{0.5}-target a nice blue colour was obtained. The L*, a* and b* values were measured on the foil using a Minolta Spectrophotometer CM-2500D with the following settings:

| | |
|---|---|
| Mask/Gloss | M/SCI |
| UV Setting | UV 100% |
| Illuminant1 | D65 |
| Observer | 10° |
| Display | DIFF & ABS. |

The following results were obtained: a*= -16, b*= -30 and L*=39.

### Example 2

Example 1 was repeated but by depositing (Ti,Al)N for 23 minutes with a cathode power of 3.7 kW on each Ti_{0.5}Al_{0.5}-target. A blue colour was obtained with the following results: a*= -18, b*= - 23 and L*= 46.

### Example 3

Example 1 was repeated but by depositing (Ti,Al)N for 23 minutes with a cathode power of 5.7 kW on each Ti_{0.5}Al_{0.5}-target. A green colour was obtained with the following results: a*= -14, b*= -7 and L*= 56.

### Example 4

Example 1 was repeated but Ar, Kr, and N₂ flows were changed to 250, 150 and 70 sccm respectively and depositing (Ti,Al)N for 23 minutes with a cathode power of 3.2 kW on each Ti_{0.5}Al_{0.5}-target. A deep blue colour was obtained with the following results: a*= -3, b*= -39 and L*= 29.

### Example 5

Example 4 was repeated in its entirety after some time. Again a deep blue colour was obtained with the following results: a*= -5, b*= -37 and L*= 31.

## Claims

1. Tool holder **characterized in** a thin outermost colouring non-oxide layer having a thickness of <0.5 µm, in which said colour is created by interference.

2. Tool holder according to claim 1 **characterized in** said colouring layer is a carbide, nitride or carbonitride of a metal from the group consisting of metals from groups IVB, VB or VIB of the periodic table, Al, Si and B or mixtures thereof.

3. Tool holder according to claim 2 **characterized in** said metal is Ti and/or Al.

4. Tool holder according to claim 3 **characterized in** said layer is TiₓAl₁₋ₓN.

5. Tool holder according to claim 4 **characterized in that** 0.1<x<0.9, preferably 0.4<x<0.7, most preferably 0.4<x<0.6.

6. Tool holder according to claim 1 **characterized in** said layer is blue with -20<a*<0, -40<b*<0 and 0<L*<95, where a*, b* and L* are coordinates of the CIELab system.

7. Tool holder according to claim 4 **characterized in** said layer is deposited on top of a TiN-layer, preferably 0.1-5 µm thick.

8. Tool holder according to any of the preceding claims **characterized in that** said colouring layer is deposited by PVD technique.
